# EUROPEAN PATENT SPECIFICATION

(11) **EP 2 857 551 B1**
(45) Date of publication and mention of the grant of the patent: **30.09.2020**
(21) Application number: 13796424.3
(22) Date of filing: 14.05.2013
(51) Int. Cl.: C23C 16/455, C23C 16/04, C23C 16/52

(54) **RESIN CONTAINER COATING DEVICE**
BESCHICHTUNGSVORRICHTUNG FÜR HARZBEHÄLTER
DISPOSITIF DE REVÊTEMENT DE CONTENANT EN RÉSINE

(30) Priority: 28.05.2012 JP 2012121130
(43) Date of publication of application: 08.04.2015
(73) Proprietor: Nissei ASB Machine Co., Ltd., Komoro-shi, Nagano 384-8585 (JP)
(72) Inventor: SHIMADA Kiyonori, Komoro-shi Nagano 384-8585 (JP)
(74) Representative: Mewburn Ellis LLP
(86) International application number: PCT/JP2013/063370
(87) International publication number: WO 2013/179886

(56) References cited:
- WO-A1-03/085165
- WO-A1-03/086878
- WO-A1-2005/035825
- JP-A- H08 509 166
- JP-A- H10 258 825
- JP-A- 2001 335 945
- JP-A- 2004 002 905
- JP-A- 2004 002 905
- JP-A- 2004 068 091
- JP-A- 2005 531 688
- US-A1- 2012 045 864

## Description

### Technical Field

The present invention relates to a resin container coating device capable of disposing a plurality of resin containers in a chamber and performing collective film formation.

### Background Art

Resins such as polyethylene, which are widely used in household goods and the like, generally have a property of transmitting a low-molecular gas such as oxygen or carbon dioxide and also a property of sorbing a low-molecular organic compound inside thereof. Therefore, when the resin is used as a container, it is known that there are various restrictions on its use target and use form as compared with other containers such as glass. For example, in a case of using a resin container by filling carbonated drinking water therein, since the carbonic acid permeates through the container to the outside, it may be difficult in some cases to maintain the quality as the carbonated drinking water for a long period of time.

Accordingly, at the time of producing a resin container, in order to solve troubles caused by the permeation of a low-molecular gas in the resin container and the sorption of a low-molecular organic compound, it is known to form a film such as DLC (Diamond Like Carbon) coating on a inner surface of the resin container by a plasma CVD film-forming technique (e.g., see Patent Document 1). Furthermore, from the requirement of improving production efficiency in recent years, a device for collectively forming this kind of coating on a plurality of resin containers are also known (e.g., see Patent Document 2).

### Prior Art Documents

### Patent Documents

Patent Document 1: Japanese Patent No. 2788412
Patent Document 2: Japanese Patent No. 4567442

JP2004002905 aims to provide a small and rotary-type chemical vapor deposition apparatus for mass production which offers high production efficiency and can be operated with a small number of high-frequency power supplies, wherein a film-forming chamber performs a single production cycle while a rotating support rotates once, and a film-forming process. The apparatus is equipped with the rotating support wherein two or more film-forming chambers housing vessels are arranged in a circle, a raw material gas introducing means for introducing raw material gas into each vessel and a high-frequency supplying means for supplying a high frequency wave to each external electrode. The apparatus deposits a chemical vapor deposition film on the inner surface of each vessel while rotating the rotating support once. The high-frequency feeding means is equipped with a fixed matching unit established for each external electrode, at least one high-frequency power supply, an automatic matching unit established for each high-frequency power supply, a high-frequency distributing means which equally supplies the predetermined film-forming chambers with high frequency waves supplied by the automatic matching unit via the fixed matching unit and a high-frequency power supply output control means for controlling the output of the predetermined high-frequency power supply. JP2001335945 discloses a system and method for coating the inside of bottles, in which the thickness fluctuation is controlled by variable condensers for impedance matching.

WO2005/035825 discloses a CVD film-forming device which is described as being capable of forming a film by applying a self-bias voltage without being restricted by the shape of a plastic container and preventing dust from adhering to electrodes. The CVD film-forming device is characterized by comprising the container side electrode concurrently served in a vacuum chamber having a space for storing the container and capable of storing the container in the space so that container internal gas does not cross container outside gas, the mouth side electrode disposed above the opening of the container in the insulated state from the container side electrode, an internal gas lead-in tube formed of an insulation material detachably disposed in the container and leading the gas in the container such as raw material gas into the container, a container internal gas supply means, a container outside gas supply means supplying the container external gas such as the raw material gas to the outside of the container in the space, an exhaust means exhausting the container internal gas, and a high frequency supply means supplying high frequencies to the container side electrode. **Summary of the Invention**

### Problems that the Invention is to Solve

However, when the present inventor has collectively formed films on a plurality of resin containers by using the conventional plasma CVD film-forming technique as described in Patent Documents 1 and 2, it has been found that there is a variation in quality of the films formed inside the resin containers. The main reason of this variation is considered to be uneven distribution of high frequency power in the internal space of the chamber. However, in order to control the distribution of the high frequency power evenly, it is necessary to change the shape of the chamber and the tip shape and arrangement of electrodes, etc., so that there is a possibility of increasing production costs owing to the complicated structure.

The present invention has been made in view of the above circumstances and an object thereof is to provide a resin container coating device which can collectively form films having equivalent quality on the plurality of resin containers.

### Means for Solving the Problems

According to the present invention there is provided a resin container coating device according to claim 1.

### Advantage of the Invention

According to the resin container coating device of the invention, a first flow rate control part for controlling the flow rate of the source gas is provided to the source gas supply path and further, second flow rate control parts for controlling the flow rate of the source gas are respectively provided to the plurality of gas branching parts. Therefore, by controlling the flow rate of the source gas to be supplied to the inside of each resin container with the second flow rate control part, films having equivalent quality can be collectively formed on a plurality of resin containers.

### Brief Description of the Drawings

FIG. 1 is a front sectional view illustrating an embodiment of a resin container coating device according to the invention.
FIG. 2 is a side sectional view of the resin container coating device shown in FIG 1.
FIG. 3 is an enlarged cross-sectional view of a main part of a chamber shown in FIG. 1.
FIG. 4 is a top view of a flow branching part of a gas supply unit shown in FIG 1.
FIG. 5 is a schematic diagram illustrating a pipe structure of the coating device shown in FIG 1.
FIG. 6 is a graph showing film-forming evaluation test results for each storage room of the chamber.

### Modes for Carrying Out the Invention

The following will explain one embodiment of the resin container coating device according to the invention with reference to the drawings.

The resin container coating device (hereinafter also simply referred to as "coating device") of the present embodiment is a device which stores a plurality of resin containers in a chamber and collectively forms films composed of a gas such as a silicon compound on an inner surface thereof by using a plasma CVD technique. Examples of the resin container are bottles for drinking waters such as carbonated beverages and fruit juices and containers for skin lotions and chemicals, but may be resin containers to be used for other purposes without being limited thereto.

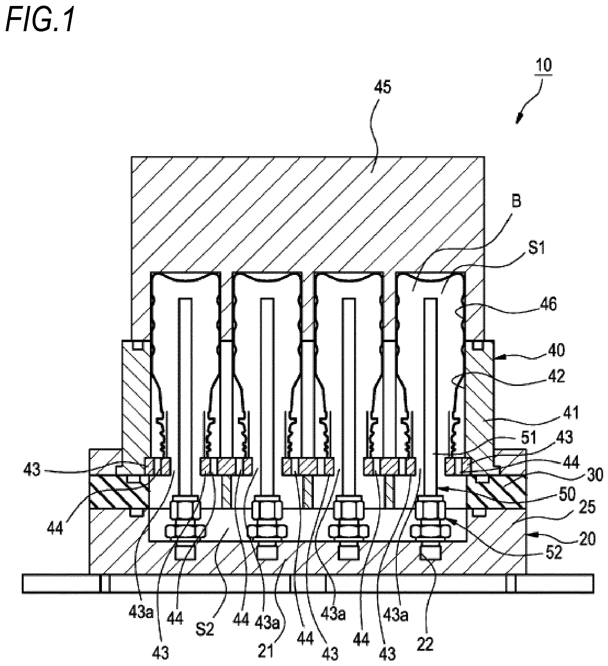

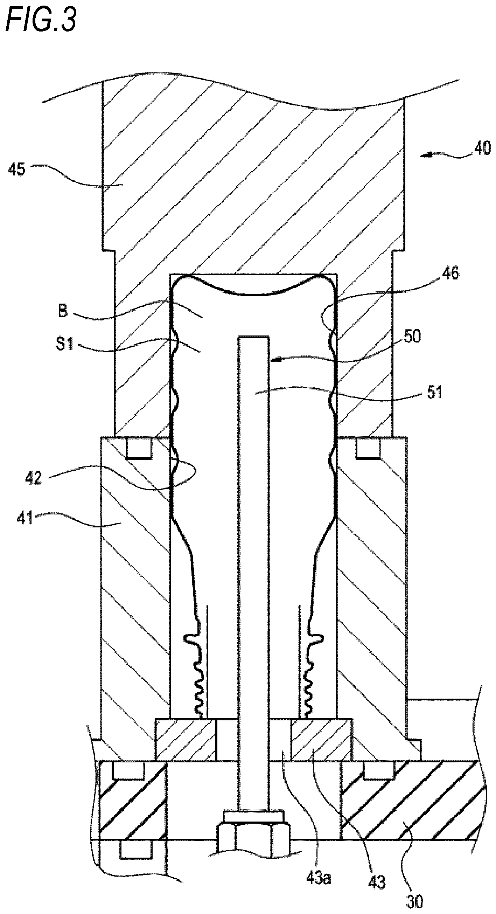

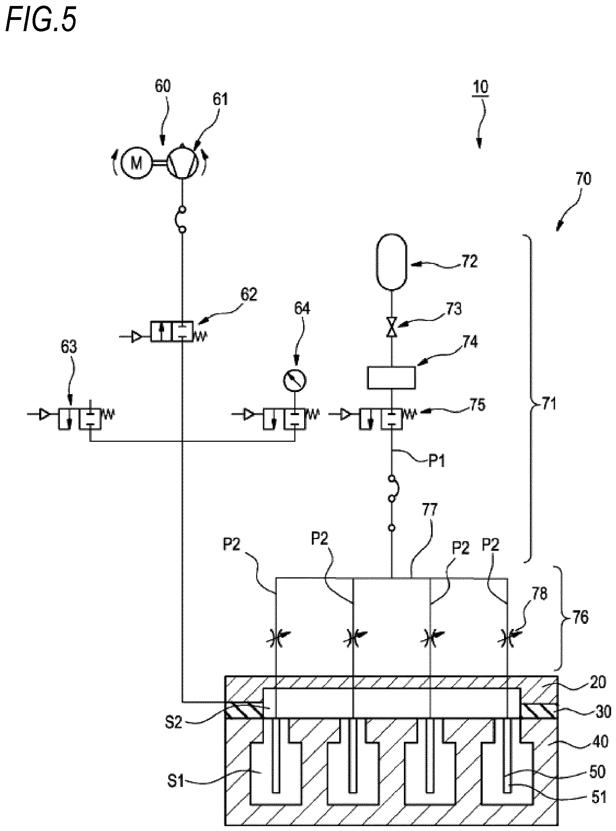

As shown in FIG. 1 to FIG. 3, the coating device 10 of the present embodiment comprises a base part 20 serving as a base, a flat-shaped insulating plate 30 disposed on the base part 20, a chamber 40 provided on the insulating plate 30 and having a plurality of storage rooms S1 that individually store each of a plurality of substantially cylindrical resin containers B, pipe-shaped internal electrodes 50 individually inserted and disposed inside the resin containers B disposed in the storage rooms S1 of the chamber 40, an exhaust unit 60 that communicates with each of the storage rooms S1 of the chamber 40 and exhausts gases, and a gas supply unit 70 that supplies a source gas to the inside of the resin containers B disposed in the storage rooms S1 of the chamber 40 (see FIG. 5).

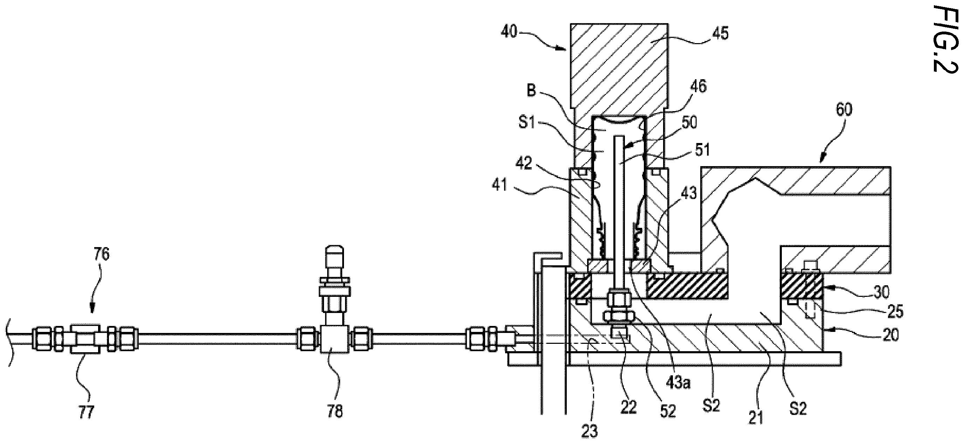

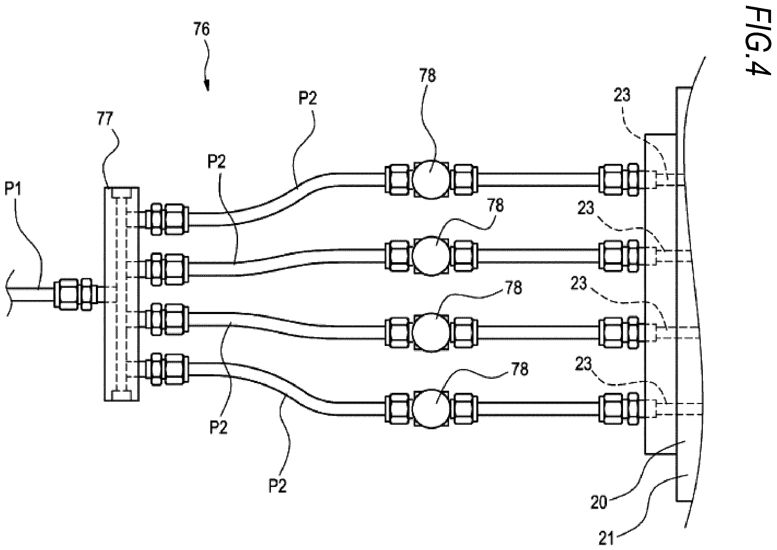

As shown in FIG. 1 and FIG. 2, the base part 20 is formed from a metal block such as stainless steel, and has a rectangular bottom plate part 21 and a peripheral wall part 25 that extends upward from the periphery of the bottom plate part 21. An internal space S2 is defined by the bottom plate part 21, the peripheral wall part 25, and the insulating plate 30. On the upper surface of the bottom plate part 21 of the base part 20, four screw holes 22 are provided at substantially equal intervals in a parallel state. Furthermore, four gas passage paths 23 are provided inside the bottom plate part 21 of the base part 20, and the gas passage paths 23 are connected to the gas supply unit 70 at the upstream end and are connected to the screw holes 22 at the downstream end (see FIG. 4). The base part 20 is electrically grounded.

As shown in FIG. 1 to FIG. 3, the chamber 40 has a chamber body 41 and a chamber lid 45 that is removably attached to the upper portion of the chamber body 41 and makes the inside of the chamber body 41 a closed state. The chamber 40 also functions as an external electrode for the plasma CVD and is electrically connected to an external high frequency power source (not shown). The chamber body 41 is formed from a rectangular metal block and four circular through holes 42 having an inner diameter slightly larger than the outer shape of the resin container B are formed along a straight line in a parallel state. The through holes 42 communicate with the internal space S2 of the base part 20. Further, a container holding plate 43 is provided at a lower portion of the through hole 42. In the container holding plate 43, an opening 43a having a diameter slightly smaller than the mouth part of the resin container B is formed at a position corresponding to each through hole 42. Since the resin vessel B to be stored in the storage room S1 is held at the portion around the opening 43a of the container holding plate 43, there is no possibility that the resin container B falls off from the through hole 42. Moreover, an exhaust port 44 is provided in the container holding plate 43 and has a configuration by which the inside and outside of the resin container B stored in each storage room S1 can be simultaneously evacuated.

In the chamber lid 45, four bottomed holes 46 having the same diameter are formed at the positions corresponding to the through holes 42 of the chamber body 41 in a state that the chamber lid 45 is put together with the chamber body 41. That is, in a state that the chamber body 41 and the chamber lid 45 are put together with each other, four storage rooms S1 for storing the resin containers B are formed of the through holes 42 of the chamber body 41 and the bottomed holes 46 of the chamber lid 45 in a state that the rooms are disposed on a straight line.

An internal electrode 50 is a hollow cylindrical pipe member such as a cylinder or a square cylinder of a metal and has a gas conductive part 51 that conducts the source gas at an inner peripheral part thereof. The internal electrode 50 is introduced into each storage room S1 through each opening 43a of the container holding plate 43. Further, the lower portion of the internal electrode 50 is screwed and joined to the screw hole 22 in the base part 20 through a metal-made piping member 52. Thereby, the internal electrode 50 is inserted into each storage room S1 of the chamber 40 and is disposed so that the electrode is positioned in the central part of the storage room S1 of the chamber 40. At this time, since the base part 20 is electrically grounded, the internal electrode 50 is consequently electrically grounded by the screwing and joining. At the same time, since the screw hole 22 communicates with the gas passage path 23 in the base part 20, the gas conductive part 51 of the internal electrode 50 is connected to the gas passage path 23 of the base part 20 and the gas supply unit.

As shown in FIG. 2, since an exhaust unit 60 communicates with the internal space S2 of the base part 20, as a result, the exhaust unit communicates with the storage room S1 of the chamber 40. Also, the exhaust unit 60 is connected to a vacuum pump 61 on the downstream side, and thus it is configured so that air in the storage room S1 of the chamber 40 is exhausted through the internal space S2 by the vacuum pump 61 (see FIG. 5). Incidentally, in the exhaust unit 60, an evacuating part 62, an air release valve 63, and a vacuum gauge protection valve 64 are disposed between the storage room S1 of the chamber 40 and the vacuum pump 61 (see FIG. 5).

In the present embodiment, as shown in FIG. 5, a gas supply unit 70 is connected to the gas conductive part 51 of the internal electrode 50 on the downstream end and is configured so as to have a source section 71 on the upstream side and a flow branching section 76 which is located at the downstream side and divides the flow of the source gas from the source section 71 into a plurality of flows. In the source section 71, a raw material tank 72 in which a raw material of the source gas is reserved and a tank stop valve 73 that manages the presence or absence of flow of the source gas from the raw material tank 72 (an example of a raw material reservoir) are disposed on the upstream side of the source gas supply path P1 that communicates with the raw material tank 72. Further, on the downstream side thereof, a mass flow controller 74 (an example of the first flow rate control part) which controls and manages the flow rate of the source gas and a gas inlet valve 75 are disposed. Incidentally, as the source gas, a gas of a silicon compound that is liquid or gas at ordinary temperature or the like is used. It is also possible to use a gas mixed with a gas such as oxygen.

In the flow branching section 76, as shown in FIG. 4 and FIG. 5, there is disposed a gas branch section 77 that branches the source gas from the source gas supply path P1 into the plurality of gas branch paths P2 (four paths in the present embodiment). Further, between the gas branch section 77 and the gas conductive parts 51 of the internal electrodes 50, that is, on the gas branch paths P2, four flow rate control valves 78 (second flow rate control part, an example of a flow rate control valve) which control the gas flow rate are disposed individually. Further, a closing degree of each of the flow rate control valves 78 is controlled individually in advance on the basis of experimental results in the past. Thereby, the source gas is supplied to the inside of the resin container B disposed in the storage room S1 of the chamber 40 finally through the flow rate control valve 78 and the gas conductive part 51 of the internal electrode 50.

The quality of a film to be formed inside the resin container B depends on the output of the high frequency wave of the external high frequency power source, the pressure of the source gas in the resin container B, the flow rate of the source gas, plasma generation time, and the like. In the present embodiment, the control for reducing the variation in the quality of the film of the resin container B between the storage rooms S1 is mainly performed by the flow rate control valve 78. Although this control is carried out experimentally, narrowing to some extent is performed based on the experimental results obtained in the past. Here, the quality of the film means water permeability, carbon dioxide gas permeability, or the like as an example but is not limited thereto, and it means the quality of any function of the film required.

The following will explain the film forming method using a coating device 10 thus configured.

First, in a state that the chamber lid 45 of the chamber 40 is removed, the resin container B is stored by inserting it from the upper portion into the through hole 42 of the chamber body 41. At this time, since the through hole 42 has an inner diameter slightly larger than the maximum cylinder diameter of the resin container B, the resin container B is held at a predetermined place in the through hole 42. Further, the internal electrode 50 is inserted and disposed inside the resin container B from the opening of the resin container B. Then, the chamber lid 45 of the chamber 40 is closed and the storage room S1 of the chamber 40 is formed in a sealed state.

Subsequently, the air in the chamber 40 is evacuated by the vacuum pump 61 at the exhaust unit 60 and the inside of the storage room S1 of the chamber 40 is made to a state near a vacuum state (hereinafter, also referred to as vacuum state). After the vacuum state is confirmed, the source gas is supplied from the raw material tank 72 due to the operation of the tank stop valve 73, the mass flow controller 74, and the gas inlet valve 75. At this time, at the flow branching section 76 of the gas supply unit 70, the source gas is branched into four gas branch paths P2 through the gas branch section 77, and the source gas is emitted from the tips of the internal electrodes 50 by passing through the flow rate control valves 78 and the gas conductive part 51 of the internal electrode 50. Thereby, the source gas is supplied to the inside of the resin container.

After the supply of the source gas, electric power is supplied from an external high frequency power source to the chamber 40. By the supplying of the electric power, plasma is generated between the chamber 40 as an external electrode and the internal electrode 50. At this time, since the internal electrode 50 is electrically grounded but the chamber 40 is electrically insulated by the insulating plate 30, a potential difference is generated between the chamber 40 and the internal electrode 50. Consequently, films are collectively formed on the inner surfaces of the plurality (four in the embodiment) of resin containers B.

As described above, according to the resin container coating device 10 of the embodiment, the gas supply unit 70 has the gas branch section 77 and four gas branch paths P2 and supplies the source gas to the inside of the resin container while communicating with the gas conductive part 51 of the internal electrode 50. On the source gas supply path P1 of the gas supply unit 70, the mass flow controller 74 (an example of the first flow rate control part) is provided and the total amount of the source gas supplied to the chamber 40 is controlled.
Further, on each of the four gas branch paths P2, the flow rate control valve 78 is installed. By controlling the closing degree of each of the four flow rate control valves, it is possible to control the balance of the flow rates of the source gas flowing through the inside of the four gas branch paths P2. That is, by controlling the closing degree of the four flow rate control valves, it is possible to control the balance of the flow rates of the source gas flowing into four resin containers. As a result, even without individually performing design changes such as the shape of the chamber 40, the shape of the internal electrode 50, and their arrangement and, in addition, the pressure and density of the source gas, the control of the high frequency power of the electrodes (the chamber 40 and the internal electrodes 50), and the like for each storage room, the films to be formed inside the plurality of resin containers B can be collectively formed in an equivalent state in quality by controlling the flow rate of the source gas with a flow rate control valve 78 provided on each gas branch path P2. This may also be understood that the influence of main causes of uneven quality of the films, which are represented by the variation of the distribution of the high frequency power in the chamber 40, is canceled (eliminated) by controlling the closing degree of the flow rate control valve 78, that is, by controlling the flow rate of the source gas flowing into the inside of each resin container. Since this configuration can be implemented only by providing the gas branch path P2 and the flow rate control valve 78, the configuration can be realized at a simple structure and a low cost.

Furthermore, according to the resin container coating device 10 of the present embodiment, since it is possible to cancel the influence of variation of the distribution of the high frequency power by controlling the closing degree of the flow rate control valve 78, the degree of freedom in designing the supply port for supplying the high frequency power to the chamber 40 is improved. In other words, in the usual design, in order to reduce the variation of distribution of the high frequency power in the inside of the chamber 40 as much as possible, the supply port of the high frequency power is disposed in the vicinity of the center of the chamber 40. However, in the embodiment, since the influence of variation of the distribution of the high frequency power can be canceled by the flow rate control valve 78, the supply port of the high frequency power may be provided anywhere in the chamber 40, so that the degree of freedom in design is improved.

Moreover, according to the resin container coating device 10 of the embodiment, since the degree of freedom in design for disposing each storage room S1 can be ensured, four storage rooms S1 of the chamber 40 can be disposed on a straight line. When there is adopted such a configuration that the plurality of storage rooms S1 are disposed in a row on a straight line, it is easy to link operation with a conveying device such as a belt conveyor for supplying the plurality of resin containers B while being aligned in a row. That is, it is possible to improve working efficiency by linking a conveying device such as a belt conveyor and a resin container coating device in the production line.

### Examples

In order to confirm the advantages of the present invention, comparative tests were carried out in cases where the control of the flow rate control valve 78 was present and absent. A material of the resin container B used in the present Example is polyethylene terephthalate and the container is a PET bottle having a weight of 12 g and a volume of 80 ml. Water permeability was used as an evaluation index.

Incidentally, the water permeability is determined by filling the resin container B with water, making the resin container B closed state with a plastic cap, storing the resin container B in this state for one day at a temperature of 38°C, and calculating the ratio of mass change before and after the storage. The column "absence of flow rate control" in Table 2 shows experimental results when the experiments were performed in a state where no flow rate control valve was provided on four gas branch paths P2 and the column "presence of flow rate control" shows experimental results when the closing degree of each of the four flow rate control valves provided on the four gas branch paths P2 was individually controlled to the closing degree as shown in Table 1.

Each closing degree in the case where the flow rate control valve 78 was controlled is shown in Table 1. Numbers of the storage rooms S1 of the chamber 40 shown in Table 1 are defined by numbering them "1", "2", "3", and "4" from the left in FIG. 1. Further, in the present Example, the closing degree is defined as the rotation number to the closing direction from a fully opened state. For example, 5/8 in the storage room 2 means a state that the valve is closed by a rotation of five eighth of one revolution from the fully open state and "1" in the storage room 3 means that the valve is rotated by one revolution. Incidentally, the flow rate control valve can be transferred from the fully open state to a completely closed state by rotating it by about 5 to 6 revolutions.

**[Table 1]**

| Storage room (No.) | 1 | 2 | 3 | 4 |
|---|---|---|---|---|
| Opening degree (rotation number) | 0 | 5/8 | 1 | 3/8 |

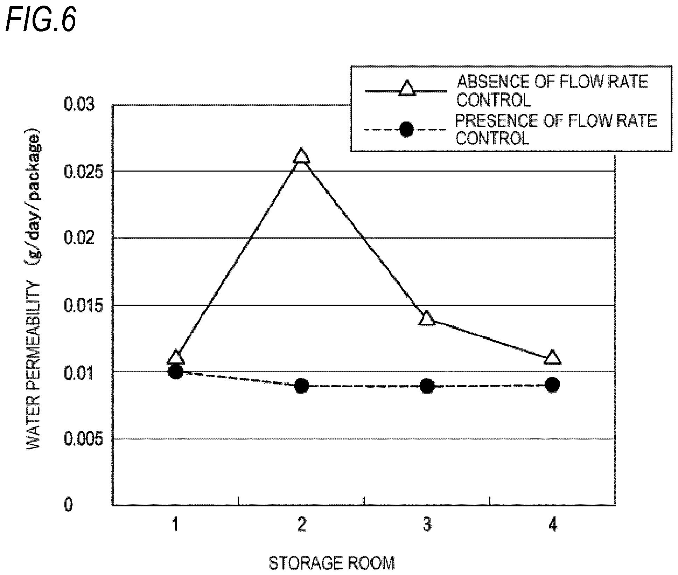

The test results are shown in Table 2 and Figure 6. In the case where flow rate control with the flow rate control valve 78 is present, there is almost no variation in the water permeability between the four resin containers B on which films are formed respectively. On the other hand, in the case where the flow rate control is absent, the water permeability of the resin container B having a number of "2" among the storage rooms S1 is 0.026 g/day/package and indicates a value larger than the values of the others. That is, in the resin container B having a number of "2", it means that the quality of the film formed inside the container is low (a large amount of water may be allowed to pass through). Incidentally, the water permeability in the case where no film is formed inside the resin container is also 0.026 g/day/package, so that it is found out that the film formed inside the PET bottle in the storage room "2" in the case where the flow rate control is absent hardly functions in terms of reducing the water permeability.

**[Table 2]**

| Storage room (No.) | Water permeability (g/day/package) | |
|---|---|---|
| | Presence of flow rate control | Absence of flow rate control |
| 1 | 0.010 | 0.011 |
| 2 | 0.009 | 0.026 |
| 3 | 0.009 | 0.014 |
| 4 | 0.009 | 0.011 |

As described above, in the case where the flow rate control valve was not provided, that is, in the case where the balance of the flow rates of the source gas flowing through the inside of the four gas branch paths P2 was not controlled, it was confirmed that there was a variation in the quality (water permeability in this example) of films formed inside the four resin containers as shown in "absence of flow rate control" in Table 2. It is considered that this result is influenced by a variation of the distribution of high-frequency power inside the chamber 40. However, as a result of controlling the four closing degrees of the flow rate control valves 78 as shown in Table 1, as shown in the column of "presence of flow rate control" in Table 2, it was confirmed that it was possible to suppress the variation in the water permeability. In other words, it was confirmed that, by controlling the closing degrees of the four flow rate control valves 78, it was possible to form films having even quality inside the four resin containers stored inside the chamber 40.

Incidentally, the invention is not limited to the embodiments described above and modifications, improvements, and the like can be appropriately made. For example, in the above Example, a plurality of storage rooms are provided in one chamber, but without being limited thereto, it is possible to provide a plurality of storage rooms by using a plurality of chambers. The number (four) of the storage rooms and the gas branch paths is also only an example. Further, the closing degree of the flow rate control valve 78 shown in Example 1 is merely illustrative and the closing degree is a value to be obtained by performing experiments for each device individually.

Moreover, the source gas and the quality (required function) of the film described above are also illustrative and may be varied depending on the applications of the resin container.

The present application is based on Japanese Patent Application No. 2012-121130 filed on May 28, 2012.

### Description of Reference Numerals and Signs

10: Resin container coating device
20: Base part
21: Bottom plate part
22: Screw hole
23: Gas passage path
25: Peripheral wall part
30: Insulating plate
40: Chamber
41: Chamber body
42: Through hole
43: Container holding part
44: Step part
45: Chamber lid
46: Bottomed hole
50: Internal electrode
51: Gas conductive part
52: Piping member
60: Exhaust unit
61: Vacuum pump
62: Evacuating part
63: Air release valve
64: Vacuum gauge protective valve
70: Gas supply unit
71: Source section
72: Raw material tank
73: Tank stop valve
74: Mass flow controller
75: Gas inlet valve
76: Flow branching section
77: Gas branch section
78: Flow rate control valve
S1: Storage room
S2: Internal space
P1: Source gas supply path
P2: gas branch path

## Claims

1. A resin container coating device (10) comprising:
a chamber (40) which stores a plurality of resin containers (B) and is an external electrode;
a plurality of internal electrodes (50) which are electrically grounded and are formed in a cylinder shape, in which gas conductive parts (51) for conducting a source gas are formed to inner peripheral parts thereof, and which are respectively inserted inside the plurality of resin containers (B) stored in the chamber (40); and
a gas supply unit (70) for supplying the source gas to the chamber (40),
wherein:
the gas supply unit (70) includes a source gas supply path (P1) that communicates with a raw material reservoir (72) in which a raw material of the source gas is reserved and a plurality of gas branch paths (P2) that branch from the source gas supply path (P1) and respectively communicate with the gas conductive parts (51) of the plurality of internal electrodes (50), and supplies the source gas to the inside of the plurality of resin containers (B) stored in the chamber (40) through the source gas supply path (P1), the plurality of gas branch paths (P2), and the gas conductive parts (51) of the plurality of internal electrodes (50), and
**characterized in that**:
the chamber (40) includes a plurality of storage rooms (S1) that individually store each of the plurality of resin containers (B) on a straight line, the source gas is supplied to the inside of each of the plurality of resin containers (B) stored in the chamber (40) so as to form a film thereto, and
a mass flow controller (74) for controlling a flow rate of the source gas is provided to the source gas supply path (P1), and flow rate control valves (78) whose closing degrees can be controlled so as to control balance of the flow rates of the source gas flowing into the plurality of resin containers (B) so as to cancel the influence of variation of high frequency power in the chamber (40) are respectively provided to the plurality of gas branch paths (P2).

## Patentansprüche

1. Harzbehälter-Beschichtungsvorrichtung (10), umfassend:
eine Kammer (40), in der eine Vielzahl von Harzbehältern (B) gelagert ist und die eine Außenelektrode ist;
eine Vielzahl von Innenelektroden (50), die elektrisch mit Masse verbunden sind und in Zylinderform ausgebildet sind, in denen gasleitende Teile (51) zum Leiten eines Quellgases als innere Umfangsteilen derselben ausgebildet sind, und die jeweils in die Vielzahl von Harzbehältern (B), die in der Kammer (40) gelagert sind, eingesetzt sind; und
eine Gaszuführungseinheit (70) zum Zuführen des Quellgases in die Kammer (40),
wobei:
die Gaszuführungseinheit (70) einen Quellgaszuführungspfad (P1) umfasst, der mit einem Rohmaterialspeicher (72) kommuniziert, in dem ein Rohmaterial des Quellgases aufbewahrt wird und eine Vielzahl von Gasabzweigpfaden (P2), die von dem Quellgaszuführungspfad (P1) abzweigen und jeweils mit den gasleitenden Teilen (51) der Vielzahl von Innenelektroden (50) kommunizieren, und das Quellgas durch den Quellgaszuführungspfad (P1), die Vielzahl von Gasabzweigpfaden (P2) und die gasleitenden Teile (51) der Vielzahl von Innenelektroden (50) in das Innere der Vielzahl von Harzbehältern (B), die in der Kammer (40) gelagert sind, zuführt, und
**dadurch gekennzeichnet, dass**:
die Kammer (40) eine Vielzahl von Lagerräumen (S1) umfasst, die jede der Vielzahl von Harzbehälter (B) auf einer geraden Linie einzeln lagern, wobei das Quellgas in das Innere jeder der Vielzahl von Harzbehältern (B), die in der Kammer (40) gelagert sind, zugeführt wird, sodass darauf ein Film gebildet wird, und
eine Massendurchflusssteuervorrichtung (74) zum Steuern einer Durchflussrate des Quellgases für den Quellgaszuführungspfad (P1) bereitgestellt ist, und Durchflussratensteuerventile (78), deren Schließgrade so gesteuert werden können, dass sie einen Ausgleich der Durchflussraten des in die Vielzahl der Harzbehälter (B) fließenden Quellgases steuern, so dass der Einfluss einer Schwankung von Hochfrequenzleistung in der Kammer (40) aufgehoben wird, jeweils für die Vielzahl der Gasabzweigpfade (P2) bereitgestellt ist.

## Revendications

1. Dispositif de revêtement de contenant en résine (10) comprenant :
une chambre (40) qui stocke une pluralité de contenants en résine (B) et est une électrode externe ;
une pluralité d'électrodes internes (50) qui sont mises à la terre électriquement et qui sont formées en forme de cylindre, dans lesquelles des parties conductrices de gaz (51) pour conduire un gaz source sont formées sur des parties périphériques internes de celles-ci, et qui sont respectivement insérées à l'intérieur de la pluralité de contenants en résine (B) stockés dans la chambre (40) ; et
une unité d'alimentation en gaz (70) pour alimenter le gaz source vers la chambre (40),
dans lequel :
l'unité d'alimentation en gaz (70) comprend un trajet d'alimentation en gaz source (P1) qui communique avec un réservoir de matière première (72) dans lequel une matière première du gaz source est réservée et une pluralité de trajets de ramification de gaz (P2) qui sont ramifiés à partir du trajet d'alimentation en gaz source (P1) et communiquent respectivement avec les parties conductrices de gaz (51) de la pluralité d'électrodes internes (50), et alimentent le gaz source vers l'intérieur de la pluralité de contenants en résine (B) stockés dans la chambre (40) à travers le trajet d'alimentation en gaz source (P1), la pluralité de trajets de ramification de gaz (P2), et les parties conductrices de gaz (51) de la pluralité d'électrodes internes (50), et
**caractérisé en ce que** :
la chambre (40) comprend une pluralité d'espaces de stockage (S1) qui stockent individuellement chacun de la pluralité de contenants en résine (B) sur une ligne droite, le gaz source est alimenté vers l'intérieur de chacun de la pluralité de contenants en résine (B) stockés dans la chambre (40) de manière à y former un film, et
une commande d'écoulement massique (74) pour commander un débit du gaz source est fournie au trajet d'alimentation en gaz source (P1), et des vannes de commande de débit d'écoulement (78) dont des degrés de fermeture peuvent être commandés de manière à commander un équilibre des débits d'écoulement du gaz source s'écoulant dans la pluralité de contenants en résine (B) de manière à annuler l'influence de variation d'une puissance haute fréquence dans la chambre (40) sont respectivement fournies à la pluralité de trajets de ramification de gaz (P2).
